# EUROPEAN PATENT APPLICATION

(11) **EP 1 265 296 A1**
(43) Date of publication of application: **11.12.2002**
(21) Application number: 02254018.1
(22) Date of filing: 10.06.2002
(51) Int. Cl.: H01L 31/0232, H01L 31/0216, H01L 27/146

(54) **Optical detector with integrated filter**

(30) Priority: 08.06.2001 GB 0113965; 08.06.2001 GB 0113964
(71) Applicant: Zarlink Semiconductor AB, 175 26 Järfälla (SE)
(72) Inventor: Eriksson, Christer, SE-11765 Stockholm (SE); Jöngren, Per-Arne, SE-18491 Auersberga (SE)
(74) Representative: Harding, Richard Patrick

(57) **Abstract**

A photodetector includes a detector responsive to incident light to generate an output signal and one or more band gap filters upstream of the broadband detector for absorbing incident photons of predetermined wavelength. The bandgap filters have a bandgap gradient across their width. The photodetector can act as a selective detector without the need for a separate optical filter.

## Description

This invention relates to the field of optoelectronics, and more particularly to an integrated photodetector suitable for use in wavelength division multiplexing applications.

Wavelength division multiplexing (WDM) is becoming an important medium for use in broadband communications. A single fiber can carry multiple wavelengths, each carrying a high speed digital channel. These must be individually detected to extract the signal carried on each wavelength.

Typically optical filters are used to separate the different wavelengths prior to detection. Sometimes, only a few WDM channels are used, in which case the channels can be quite wide in terms of optical bandwidth. For such systems, bandgap engineered detector chips can be used to obviate the need for optical filters. These solutions are not effective for narrowband channels.

An alternative solution is to combine a broadband filter with a discrete filter, such as a dichroic mirror, Bragg grating etc. The disadvantage of this solution is the need for extra filter components, and this results in high component cost.

European patent no. 901,170 discloses a photodetector with filter layer having a given bandgap. Such a photodetector is not capable of filter a wide band of signals and also suffers from re-emission that occurs when charge carriers recombine.

US patent no. 4,213,138 discloses a dual-wavelength photodetector that has two absorption layers that respond to different wavelengths in series.

In order to provide a practical photodetector, the original photon power outside the detected wavelength should be reduced to between 1 and 1/10% of its original power. This is not possible with prior art proposals. There is a need to provide an efficient selective low pass detector that overcomes these drawbacks of the prior art.

According to the present invention there is provided an integrated photodetector comprising a detector responsive to incident light to generate an output signal; and a bandgap filter arrangement upstream of said detector and integral therewith for absorbing incident photons, said bandgap filter arrangement having a bandgap that varies in the upstream direction.

In one embodiment the structure includes a plurality of filters with progressively increasing bandgaps. In another embodiment the bandgap forms a gradient through the filter, with the bandgap on the input side being less than on the output side so that photons of gradually higher energy are absorbed as the light passes through the filter.

The invention is preferably implemented using an InGaAsP system. The filter layers are preferably InGaAsP and the detector InGaAs. The detector is typically a PIN diode.

In another aspect the invention provides a method of detecting light of a selected wavelength comprising the steps of passing incident light through a bandgap filter arrangement to absorb incident photons, said bandgap filter arrangement having a bandgap that varies in the upstream direction; and detecting light passing through said bandgap filter arrangement with a detector responsive to incident light to generate an output signal, said detector being integral with said bandgap filter arrangement.

The invention will now be described in more detail, by way of example, only with reference to the accompanying drawings, in which:-
Figure 1a is a schematic diagram of a first embodiment of a detector with a band gap optical filter;
Figure 1b is an equivalent circuit of the structure shown in Figure 1a;
Figure 2a is a schematic diagram of a second embodiment of a detector with a band gap optical filter;
Figure 2b is an equivalent circuit of the structure shown in Figure 2a;
Figure 3a is a schematic diagram of a third embodiment of a detector with a band gap optical filter;
Figure 3b is the equivalent circuit of the structure shown in Figure 3a;
Figure 4a is a schematic diagram of a fourth embodiment of a detector with a band gap optical filter;
Figure 4b is the equivalent circuit of the structure shown in Figure 4a; and
Figure 5 shows the complete structure of on embodiment of a detector with a band gap optical filter biased band gap optical filter.

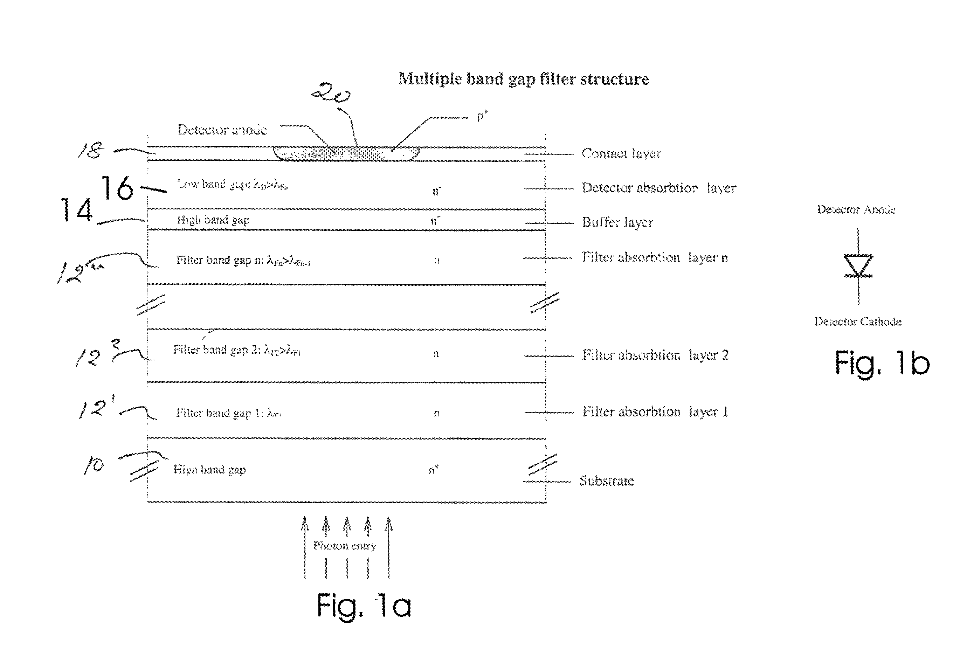

Figure 1a shows a schematic PIN diode implementation of a detector with a low pass bandgap optical filter. The structure shown can be formed by epitaxial growth techniques in a manner known *per se.*

A high band gap, heavily doped n⁺ substrate 10 of InP has deposited thereon a series of n type filter bandgap layers 12¹... 12ⁿ of InGaAsP. The band gap of the substrate 10 is sufficiently high to allow photons in the expected wavelength range to pass through the layer without absorption. Each filter layer 12¹... 12ⁿ has a bandgap n corresponding to a wavelength λ_{Fn}, i.e. the first layer has a bandgap 1 corresponding to a wavelength λ_{F1}, the second layer has a bandgap 2 corresponding to a wavelength λ_{F2}, and so on. Photons at wavelength λ_{Fn} will therefore be absorbed in the layer 12ⁿ.

The layers 12¹... 12ⁿ are arranged such that the absorption wavelengths progressively increase, i.e. λ_{Fn} > λ_{Fn-1}. This means that the bandgaps progressively decrease. Thus, the shorter wavelengths with higher energy are absorbed in the lower layers and the longer wavelengths with less energy are absorbed in the higher layers, where the bandgaps are lower.

On top of the layer 12ⁿ is grown a high bandgap InP n type or n⁺ type buffer layer 14. Low band gap InGaAs detector layer 16, of n⁻ conductivity type, is formed on buffer layer 14, which serves to separate the detector layer 16 from the filter layers 12ⁿ. This detector layer 16 has a bandgap suitable for absorbing photons of wavelength λ_{D}, that is the detector layer 16 has a bandgap equal to the target wavelength for detection λ_{D}, which is greater than λ_{Fn}. Thus photons passing through the filter layers 12ⁿ pass through the high band gap buffer layer 14 to be absorbed by the detector layer 16.

On top of layer 16 is deposited a contact layer 18 with a heavily doped p⁺ region 20 providing an anode for the detector layer 16. The equivalent circuit of this arrangement is shown in Figure 1b.

In operation, incident photons pass through filter layers 12ⁿ. Photons having an energy less than a certain value such that their wavelength λ < λ_{Fn} are absorbed, leaving only photons of wavelength λ > λ_{Fn} to reach the detector layer 16.

The detector layer 16, which does not have to be highly discriminating due to the presence of the upstream filters, develops an output signal developed across the structure that depends on the intensity of incident light the substrate 10.

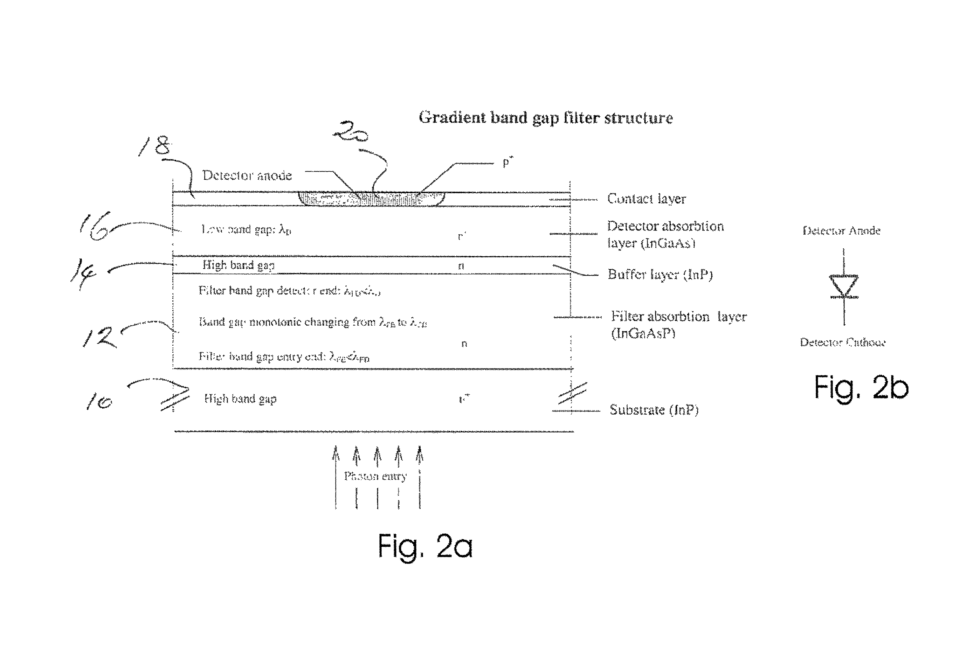

In an alternative arrangement shown in Figure 2a, instead of arranging the layers in a stack, as shown in Figure 1a, the single InGaAsP filter layer 12 has a bandgap that progressively decreases across its thickness. The bandgap on the entry side is greater than that on the exit side. A gradient is formed between the entry and exit side so that so that photons of gradually decreasing energy are absorbed as they move through the layer. The higher energy photons of shorter wavelength are absorbed on the entry side. The equivalent circuit for Figure 2a is shown in Figure 2b.

While the above described embodiments represent an improvement over the prior art, charge carriers liberated by the absorbed photons in the filter layer can combine to cause photon re-emission, which can impact on efficiency.

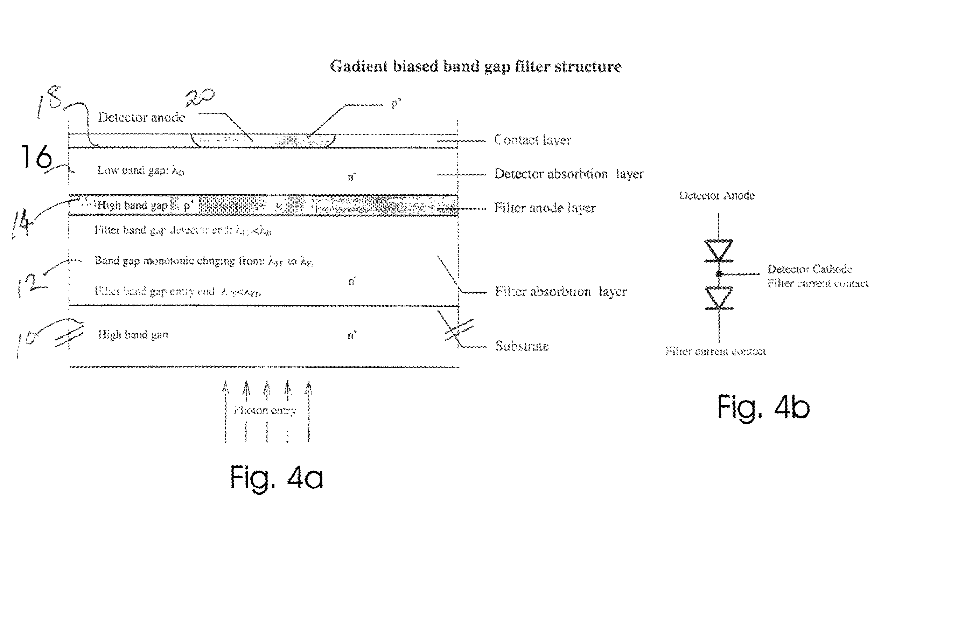

This problem is addressed in the embodiments of Figures 3a and 4a, where a pn junction is associated with each filter layer to remove any liberated charge carriers before than can recombine to cause re-emission.

In Figure 3a the same reference numerals are employed as in Figure 1a. The structure is similar to that shown in Figure 1a, except that a heavily doped p⁺ type high band gap anode layer 14ⁿ is grown on top of each filter layer 12ⁿ. In addition to serving as a buffer layer, this p⁺ type layer creates a pn junction with the underlying n⁻ type filter layer 12ⁿ. In operation, this pn junction is reverse biased to create an electric field in the bandgap filter that removes the liberated charge carriers before they have time to recombine.

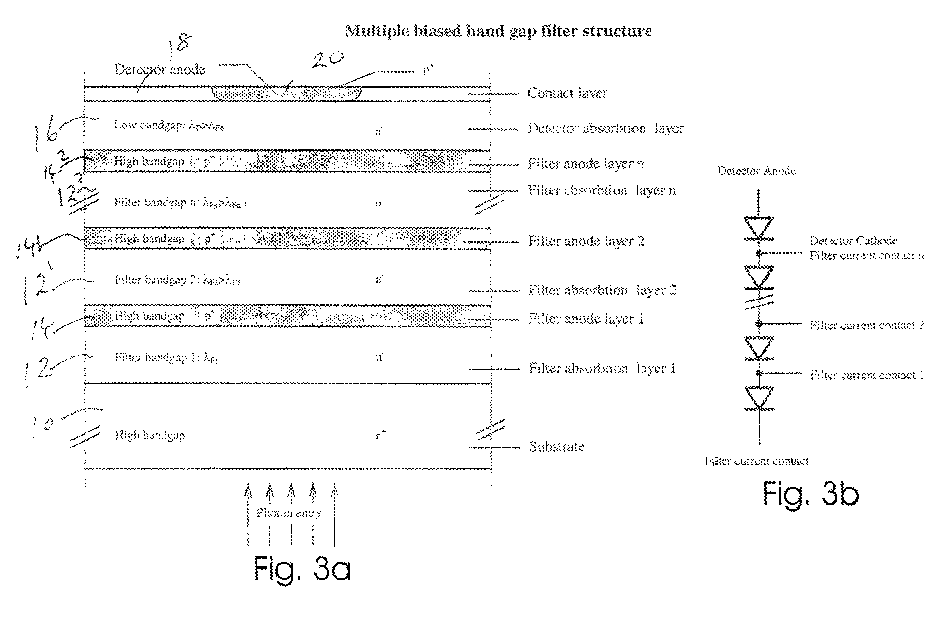

The equivalent circuit for Figure 3a is shown in Figure 3b.

Figure 4a shows a gradient structure similar to that shown in Figure 2a, but with a single heavily doped p+ anode layer 14 on top of the filter layer 12 with the bandgap gradient. The equivalent circuit is shown in Figure 4b. This embodiment works in a similar manner to that shown in Figure 2b except that the pn junction created by the layers 12 and 14 creates an electric field when reverse biased that removes the liberated charge carriers before recombination can occur.

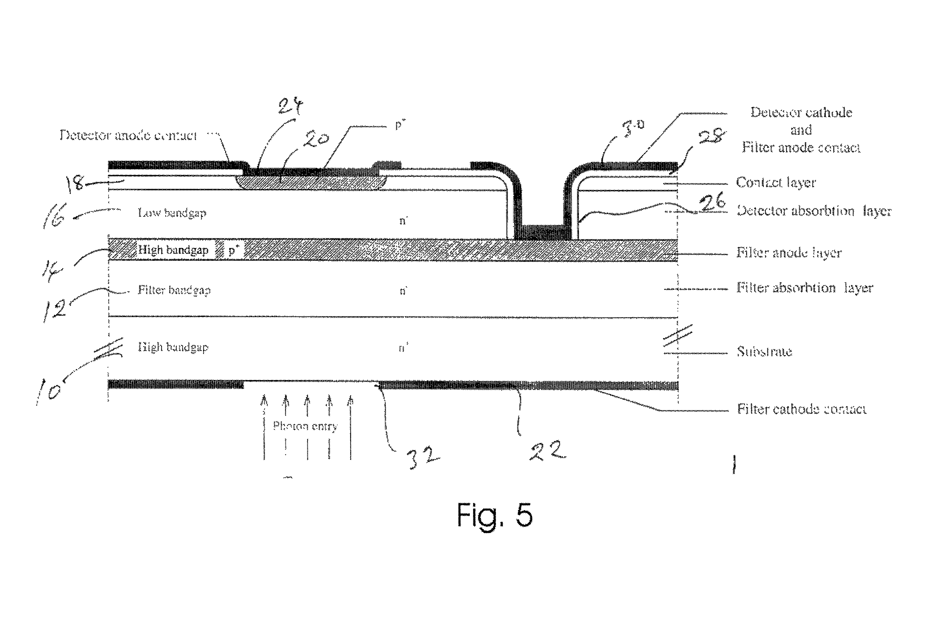

A practical example of the embodiment of Figure 4a is shown in Figure 5. This embodiment is implemented using an InGaAsP (Indium Gallium Arsenic Phosphorus) semiconductor material system, although it will be apparent to one skilled in the art that other semiconductor material systems can be used. The various layers are formed by doping semiconductor materials in a manner known *per se.* The structure is epitaxially grown on the InP substrate 10. The filter layers are quaternary mixtures (InGaAsP) and the detector is a ternary mixture of (InGaAs). The quaternary mixture of InGaAsP makes it possible to design a range of energy bandgaps, while still maintaining the same lattice constant as for InP.

The filter layer 12 has a variable bandgap across its width as described with reference to Figure 4a, although it will be appreciated that it can also consist of a stack of alternate layers as described with reference to Figure 3a.

The top contact layer 18 is formed on the detector layer 16 and has p+ contact region 20.

A via 26 is etched into the detector layer to reach the anode filter layer 14. An insulating layer 28 is then deposited over the contact layer 18 and the sidewalls of the via 16. Metal contacts 24 and 30 are then added to reach the contact region 20 and the anode layer 14 forming the p layer of the pn junction. Contact layer 24 provides the anode for the detector layer 16. Contact layer 28 serves as the cathode for the detector layer 16 and the anode for the pn junction of the filter layer. Contact layer 22 serves as a cathode contact for the filter. This has a window 32 for the admission of photons into the device.

The described photodetector is effective at removing short wavelength components, and as a result the detector layer 16 with a low band gap does not need to be highly discriminating.

It will be appreciated that the invention makes extra filter components unnecessary in WDM applications since the filter layer(s) absorb photons below a certain cut-off wavelength. The structure attenuates low wavelength photonic power while over a certain wavelength range the device will exhibit high responsivity.

## Claims

1. An integrated photodetector comprising a detector responsive to incident light to generate an output signal; and a bandgap filter arrangement upstream of said detector and integral therewith for absorbing incident photons, **characterized in that** said bandgap filter arrangement having a bandgap that varies in the upstream direction.

2. An integrated photodetector as claimed in claim 1, **characterized in that** said bandgap progressively decreases in the upstream direction.

3. An integrated photodetector as claimed in claim 1, **characterized in that** said filter arrangement comprises a stack of filter layers, each having a different bandgap.

4. An integrated photodetector as claimed in claim 3, **characterized in that** the bandgap of said layers of said stack progressively decreases in the upstream direction.

5. An integrated photodetector as claimed in claim 1, **characterized in that** said filter arrangement comprises a filter layer having a progressively varying bandgap in the upstream direction across said filter layer.

6. An integrated photodetector as claimed in claim 4, **characterized in that** said filter arrangement comprises a filter layer having a progressively varying bandgap in the upstream direction across said filter layer.

7. An integrated photodetector as claimed in claim 6, **characterized in that** the bandgap of said layer progressively decreases in the upstream direction.

8. An integrated photodetector as claimed in claim 1, further comprising a layer of opposite conductivity type associated with said filter arrangement to create a pn junction for removing liberated charge carriers.

9. An integrated photodetector as claimed in claim 3, **characterized in that** it further comprises a layer of opposite conductivity type associated with each of said layers of said stack to create a pn junction for removing liberated charge carriers.

10. An integrated photodetector as claimed in claim 5, **characterized in that** it further comprises a layer of opposite conductivity type associated with said filter layer to create a pn junction for removing liberated charge carriers.

11. An integrated photodetector as claimed in claim 1, **characterized in that** said detector comprises an absorption layer overlying said bandgap filter arrangement.

12. An integrated photodetector as claimed in claim 11, **characterized in that** it further comprises a buffer layer between said absorption layer and said bandgap filter arrangement.

13. An integrated photodetector as claimed in any one of claims 1 to 12, **characterized in that** said at bandgap filter arrangement comprises at least one filter layer made of a quaternary mixture of InGaAsP.

14. A method of detecting light of a selected wavelength comprising wherein incident light is passed through a bandgap filter arrangement to absorb incident photons, and detecting light passing through said bandgap filter arrangement is detected with a detector responsive to incident light to generate an output signal, said detector being integral with said bandgap filter arrangement, **characterized in that** said bandgap filter arrangement has a bandgap that varies in the upstream direction.

15. A method as claimed in claim 14, **characterized in that** said filter arrangement comprises a stack of filter layers, each having a different bandgap.

16. A method as claimed in claim 15, **characterized in that** the bandgap of said layers of said stack progressively decreases in the upstream direction.

17. A method as claimed in claim 15, **characterized in that** said filter arrangement comprises a filter layer having a progressively varying bandgap in the upstream direction across said filter layer.

18. A method as claimed in claim 17, **characterized in that** said filter arrangement comprises a filter layer having a progressively varying bandgap in the upstream direction across said filter layer.

19. A method as claimed in claim 18, **characterized in that** the bandgap of said layer progressively decreases in the upstream direction.

20. A method as claimed in claim 14, **characterized in that** a layer of opposite conductivity type is associated with said filter arrangement to create a pn junction, and said pn junction is reverse biased to remove liberated charge carriers.

21. A method as claimed in claim 18, **characterized in that** a layer of opposite conductivity type is associated with each of said layers of said stack to create a pn junction, and said pn junction is reverse biased to remove liberated charge carriers.

22. A method as claimed in claim 18, **characterized in that** a layer of opposite conductivity type is associated with said filter layer to create a pn junction for removing liberated charge carriers.

23. A method as claimed in claim 14, **characterized in that** light passing through said filter arrangement is detected in a detector overlying said bandgap filter arrangement.
